# EUROPÄISCHE PATENTSCHRIFT

(11) **EP 0 879 373 B1**
(45) Veröffentlichungstag und Bekanntmachung des Hinweises auf die Patenterteilung: **05.01.2005**
(21) Anmeldenummer: 97946999.6
(22) Anmeldetag: 09.10.1997
(51) Int. Cl.: F16K 31/00, H01L 41/09, H01L 41/083, F02M 47/02

(54) **PIEZOELEKTRISCHER AKTUATOR**
PIEZOELECTRIC ACTUATOR
ACTIONNEUR PIEZOELECTRIQUE

(30) Priorität: 07.12.1996 DE 19650900
(43) Veröffentlichungstag der Anmeldung: 25.11.1998
(73) Patentinhaber: ROBERT BOSCH GMBH, 70442 Stuttgart (DE)
(72) Erfinder: HEINZ, Rudolf, D-71272 Renningen (DE); KIENZLER, Dieter, D-71229 Leonberg (DE); POTSCHIN, Roger, D-74336 Brackenheim (DE); SCHMOLL, Klaus-Peter, D-74251 Lehrensteinsfeld (DE); BOECKING, Friedrich, D-70499 Stuttgart (DE)
(86) Internationale Anmeldenummer: PCT/DE1997/002306
(87) Internationale Veröffentlichungsnummer: WO 1998/025060

(56) Entgegenhaltungen:
- DE-A- 4 228 974
- GB-A- 1 320 057
- JP-A- 7 226 544
- US-A- 4 460 842
- US-A- 4 669 660
- US-A- 5 070 486
- US-A- 5 406 162
- US-A- 5 477 102

## Beschreibung

### Stand der Technik:

Ein Aktuator der gattungsgemäßen Art ist durch die US-A-4 460 842 bekannt. Dort wird der piezoelektrische Körper durch eine Metallhülse vorgespannt, die durch seitliche Einschnitte eine erhöhte elastische Verformbarkeit erhält. Durch in die Hülse axial eingeschraubte Endteile wird dabei der piezoelektrische Körper unter Spannung gesetzt. Hierbei ergeben sich Probleme bezüglich der Kontaktierung des piezoelektrischen Körpers und der einzelnen Laminate. Die Zuleitung der elektrischen Hochspannung des Aktuators muss isoliert durch die verdrehbaren Endstücke geführt werden. Eine solche Lösung ist sehr aufwendig herzustellen, problematisch bei der Montage und problematisch bei der Einhaltung der notwendigen Isolation der zugeführten Hochspannung.

Durch die JP-A-7-22 65 44 ist ferner ein piezoelektrisches Gerät bekannt, das aus aufeinander geschichteten Laminaten besteht, die an den schmalen Stirnseiten kontaktiert sind. Dazu sind gewellte Bänder vorgesehen, die im Wechsel je ein Laminat überspringen. Die Bänder liegen dabei flächig auf dünnen, leitenden, die Laminate stirnseitig abdeckenden Deckplatten auf und sind dort mit den Laminaten unlösbar verbunden. Pro Stirnseite sind dabei zwei je einem Potential zugeordnete Deckplatten nebeneinanderliegend angeordnet. Diese Bänder müssen unter einem vorgegebenen Anpressdruck an den Stirnseiten der Laminate angelegt werden, um einen spaltenfreien Verbund des Laminats zu sichern und eine sichere Kontaktierung an den Schmalseiten der Laminate zu erzielen. Sie sind aber in Verbindung mit den nur dünnen Deckplatten und der Art der Kontaktierung wenig geeignet, eine hohe mechanische Vorspannung auf den Aktuatorkörper aufzubringen, der hohe Stellkräfte übertragen soll, und insbesondere dem rauem Betrieb eines Kraftfahrzeugs genügen soll.

Durch die US-A 5 406 162 ist weiterhin ein elektrostriktives Element aus geschichteten keramischen Laminaten bekannt, die axial kontaktiert sind. Zur Erzeugung einer Vorspannung der Laminate ist eine auf Deckplatten wirkende Schraubenfeder vorgesehen. Eine solche Konstruktion bedingt eine Vorspannung einhaltende Verschweißung der Federenden mit den Stirnblechen, was einen hohen Herstellungsaufwand bedeutet. Die Spiralfeder wird durch Anlage an dem piezoelektrischen Körper geführt. Eine Kontaktierung muss in aufwendiger Weise zwischen Spiralfederwindungen gut isoliert und schüttelfest hindurchgeführt werden.

### Vorteile der Erfindung

Der erfindungsgemäße piezoelektrische Aktuator mit den Merkmalen des Patentanspruchs 1 hat den Vorteil, dass mit Hilfe der Federbügel eine leicht herzustellende sichere und schüttelfeste Verspannung der Laminate des piezoelektrischen Körpers erreicht werden kann, wobei der Kontakt der Federbügel sich nur auf die axiale Einwirkung auf die Platten beschränkt und der piezoelektrische Körper ansonsten frei von Berührungen mit diesen Federbügeln ist. Dabei bleibt genügend Raum für die elektrische Kontaktierung des piezoelektrischen Körpers, was mit leichtem Zugang seitlich erfolgen kann. In den Unteransprüchen sind vorteilhafte Ausgestaltungen und Weiterbildungen der mit dem Patentanspruch 1 gegebenen Lösung dargestellt.

Die Spannelemente sind bevorzugt mit geringer Steifigkeit ausgebildet, derart daß sich ihre Spannkräfte bei pulsierenden Bewegungen des piezoelektrischen Körpers nur relativ wenig ändern, wobei insbesondere das Maß der Kraftänderung gering im Vergleich zur wirksamen Kraft sein soll.

### Zeichnungen:

Im übrigen wird hinsichtlich bevorzugter Merkmale der Erfindung auf sowie die nachfolgende Erläuterung der Zeichnung verwiesen, anhand der besonders vorteilhafte Merkmale und Ausführungsformen beschrieben werden. Dabei zeigt
- Fig. 1: eine teilweise geschnittene Darstellung einer ersten Ausführungsform eines erfindungsgemäßen Aktuators,
- Fig. 2: ein Schnittbild entsprechend der Schnittlinie II-II in Fig. 1,
- Fig. 3: ein der Fig. 2 entsprechendes Schnittbild einer abgewandelten Ausführungsform,
- Fig. 4: ein Schnittbild einer weiteren abgewandelten Ausführungsform,
- Fig. 5: eine Darstellung einer nicht beanspruchten Ausführungsform, bei der zwischen stirnseitig am Aktuator angeordneten Platten federnde Spannbänder angeordnet sind,
- Fig. 6: eine Ansicht entsprechend dem Pfeil VI in Fig. 5,
- Fig. 7: verschiedene Varianten für federnde Spannbänder,
- Fig. 8: ein Schnittbild einer nicht beanspruchten Ausführungsform, bei der zwischen stirnseitigen Platten des Aktuators eine Federhülse angeordnet ist,
- Fig. 9: eine Gesamtdarstellung eines Einspritzventiles,
- Fig.10: ein Schnittbild einer weiteren nicht beanspruchten Ausführungsform eines Aktuators und
- Fig.11: eine vorteilhafte Variante für die Halterung eines als Umspannung des piezoelektrischen Körpers dienenden Federbandes.

### Beschreibung der Ausführungsbeispiele:

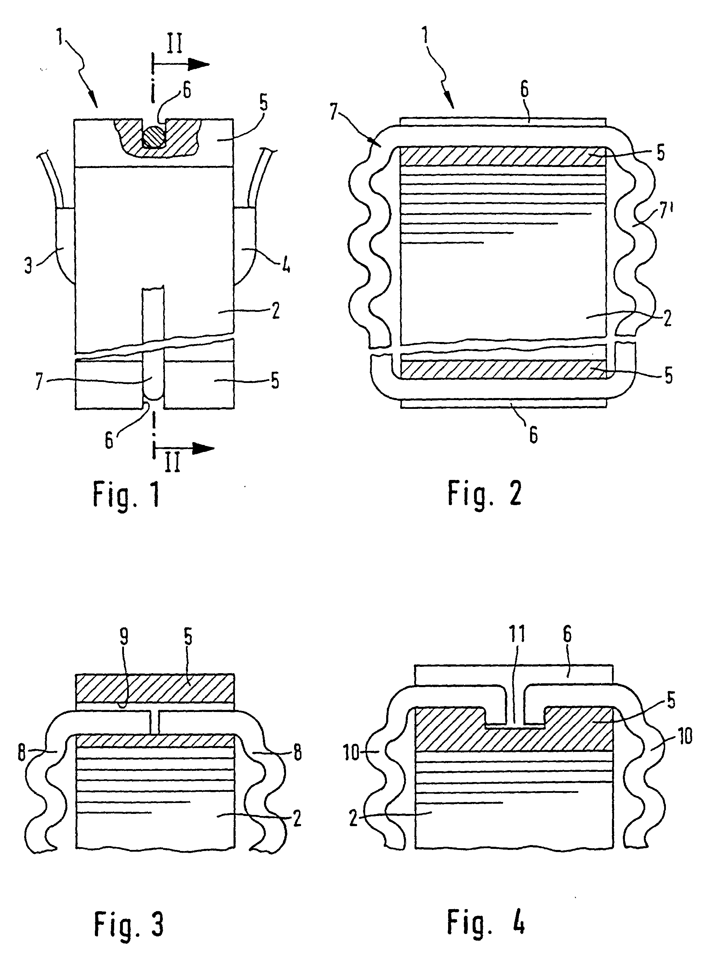

Gemäß den Fig. 1 und 2 besitzt ein piezoelektrischer Aktuator 1 einen piezoelektrischen Körper 2, der beispielsweise aus einer Vielzahl von Schichten aus piezokeramischen Material bestehen kann, zwischen denen jeweils elektrisch leitende Schichten angeordnet sind, die abwechselnd mit einem elektrischen Anschluß 3 bzw. einem elektrischen Anschluß 4 elektrisch leitend verbunden sind, so daß der piezoelektrische Körper 2 bei Verbindung der Anschlüsse 3 und 4 mit einer nicht dargestellten pulsierenden elektrischen Spannungsquelle oder einer Wechselspannungsquelle in bekannter Weise zu pulsierenden Bewegungen angeregt wird, bei denen sich der Abstand der in Fig. 1 oberen und unteren Stirnseiten des piezoelektrischen Körpers 2 ändert.

Die genannten Stirnseiten sind mit stabilen Platten 5 überdeckt, die im Beispiel der Fig. 1 und 2 mit einer mittigen stirnseitigen Nut 6 versehen sind. Dabei ist die Nut 6 der in den Fig. 1 und 2 oberen Platte 5 parallel zur Nut 6 in der unteren Platte 5 angeordnet. Die Nuten 6 dienen zur Aufnahme und Halterung eines als geschlossener Ring ausgebildeten Federbügels 7, welcher den piezoelektrischen Körper 2 sowie die Platten 5 rahmenartig umschließt und mit Querbereichen in den Nuten 6 aufgenommen ist. Der Federbügel 7 besitzt seitlich des piezoelektrischen Körpers 2 erstreckte elastische Abschnitte 7', welche auf Zug vorgespannt sind und dementsprechend den piezoelektrischen Körper 2 zwischen den Platten 5 unter eine Druckvorspannung setzen. Zur Erzielung einer vorzugebenden Federsteifigkeit besitzen die Abschnitte 7' ein oder mehrere Sicken bzw. Wellenform, wobei die zwischen den Platten 5 wirksamen Zugkräfte die Sicken bzw. Wellen aufzubiegen suchen.

Die Ausführungsform nach Fig. 3 unterscheidet sich von der vorangehend beschriebenen Ausführungsform unter anderem dadurch, daß am piezoelektrischen Körper 2 zwei voneinander separate Federbügel 8 angeordnet sind, und daß in stirnseitigen Platten 5 am piezoelektrischen Körper 2 jeweils eine Bohrung 9 vorgesehen ist, in die die Federbügel 8 mit abgewinkelten Enden eingesteckt sind.

Die Ausführungsform nach Fig. 4 unterscheidet sich von der Ausführungsform der Fig. 1 und 2 ebenfalls dadurch, daß zwei Federbügel 10 vorgesehen sind. Diese Federbügel 10 besitzen wiederum in den Nuten 6 von Platten 5 aufgenommene Endbereiche, welche jedoch hakenförmig ausgebildet sind, wobei die hakenförmigen Enden jeweils in eine innerhalb der Nuten 6 ausgebildeten Vertiefung 11 eingreifen.

Bei allen vorangehend beschriebenen Ausführungsformen können die Federbügel 7,8 bzw. 10 aus einem Federstahldraht mit kreisförmigen Querschnitt bestehen.

Grundsätzlich sind jedoch auch andere Querschnitte und andere Federmaterialien denkbar.

Soweit zwei separate Bügel 8 bzw. 10 angeordnet und elektrisch gegeneinander isoliert sind, können diese Bügel auch als elektrische Anschlüsse angeordnet und mit entsprechenden Kontaktflächen am piezoelektrischen Körper 2 durch Pressung, Lötverbindung od.dgl. elektrisch verbunden sein.

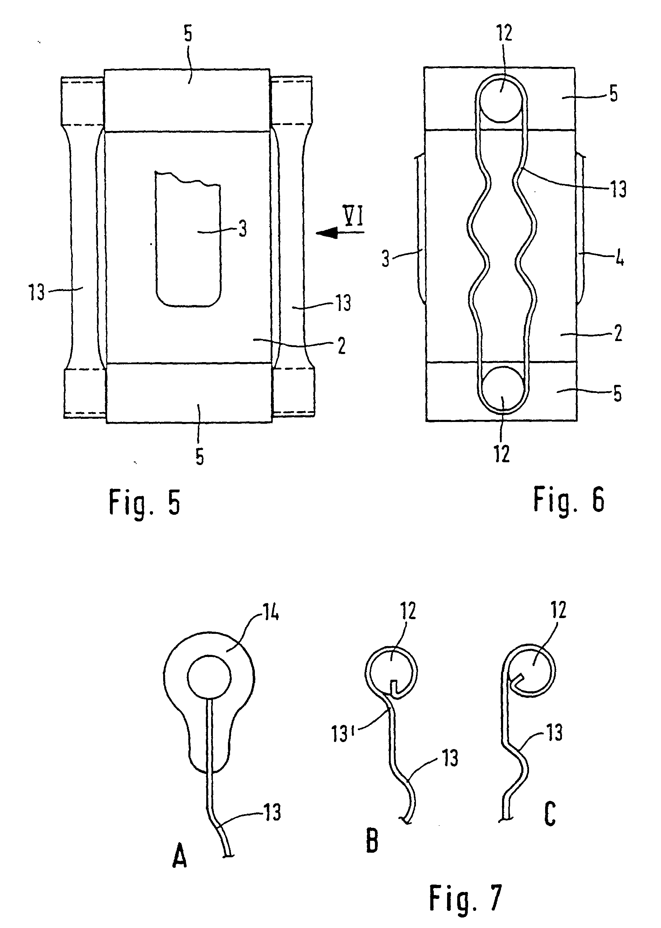

Bei der in den Fig. 5 und 6 dargestellten (nicht beanspruchten) Ausführungsform sind an den stirnseitigen Platten 5 jeweils seitliche Zapfen 12 angeordnet, welche zur Halterung von federnden Spannbändern 13 dienen.

Diese können gemäß Fig. 6 nach Art einer um die Zapfen 12 der Platten 5 umlaufenden Schlaufe ausgebildet sein und im Bereich zwischen den Zapfen 12 eine wellenförmige Form aufweisen, wobei die zwischen den Zapfen 12 wirksamen Spannkräfte die genannten Wellen aufzubiegen suchen. Im Bereich der Zapfen 12 können die Spannbänder 13 eine vergleichsweise große Breite besitzen, während die gewellten Bereiche der Spannbänder 13 schmaler sind.

Durch die zwischen den Zapfen 12 wirksamen Zugkräfte der Spannbänder 13 wird der piezoelektrische Körper 12 wiederum unter eine ständig wirksame Druckvorspannung gesetzt.

Die Fig. 7 zeigt abgewandelte Ausführungsformen der Spannbänder 13. Gemäß Abbildung A kann jedes Spannband 13 an seinen Enden mit einem Auge 14 versehen sein, welches sich jeweils auf einen der Zapfen 12 aufschieben läßt. Nach den Bildern B und C können die Zapfen 12 jeweils einen Axialschlitz aufweisen, welcher jeweils ein Ende eines um den jeweiligen Zapfen 12 herumgelegten Endbereiches eines Spannbandes 13 aufnimmt.

Im Beispiel des Bildes B besitzt das Spannband 13 im Bereich des Zapfens 12 einen S-förmigen Bereich 13', welcher aufgrund seiner Form federnd ist, d.h. starke Zugkräfte suchen diesen Bereich 13' glattzuziehen.

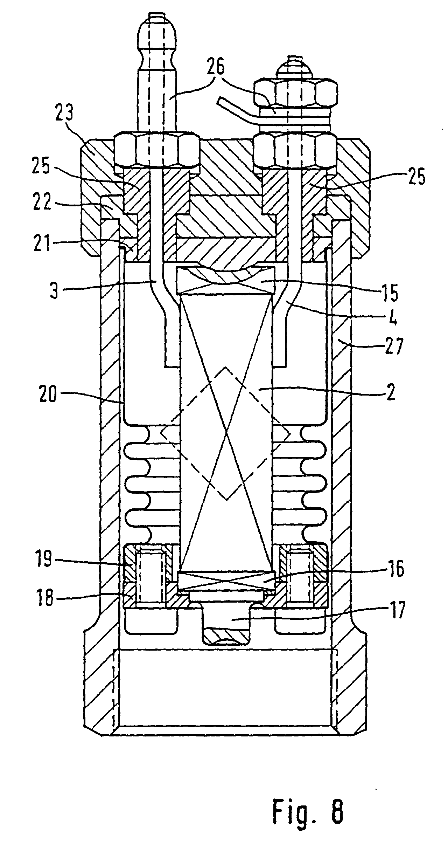

Bei der Ausführungsform nach Fig. 8 ist der piezoelektrische Körper 2 an seinem einen Stirnende mit einer stirnseitig konkaven Platte 15 und an seinem anderen Ende mit einer Platte 16 versehen, die auf ihrer vom Körper 2 abgewandten Seite einen stößelartigen Fortsatz 17 aufweist. Der Rand der Platte 16 wird von einem Ringflansch 18 aufgenommen, welcher mit einem ringförmigen Boden 19 einer Federhülse 20 verbunden ist, deren anderes Ende an einem Boden 21 gehaltert ist, der mit einer innenseitigen Konvexität in die Konvatität auf der zugewandten Seite der Platte 15 eingreift. Die Federhülse 20 steht unter einer größeren Zugspannung, derart, daß die Böden 19 und 21 den piezoelektrischen Körper 2 einer entsprechenden Druckvorspannung aussetzen.

Die Federhülse 20 besitzt in ihrem in Fig. 8 oberen Bereich eine im wesentlichen zylindrische Form, während der untere Bereich balgartig gewellt ist, wobei die Wellen vorzugsweise jeweils halbkreisförmige Bögen bilden, wie es in Fig. 8 dargestellt ist.

Die Wandstärke der Hülse, welche vorzugsweise aus Federstahl besteht, kann zwischen 0,1 bis 0,6 mm, vorzugsweise bei etwa 0,3 mm liegen. Die maximale Zugspannung sollte im gewellten Bereich 800 bis 900 N/mm² nicht überschreiten. Aufgrund der mehrfach angeordneten Wellen kann die Gesamtzugspannung der Federhülse 20 bei etwa 500 bis 1.500 N liegen. Bei einem Querschnitt des piezoelektrischen Körpers von größenordnungsmäßig 1 cm² ergibt sich dann eine Druckvorspannung von ca. 500 bis 2.000 N/cm².

Auf dem Boden 21 ist eine Trägerplatte 22 angeordnet, die ihrerseits in einem napfförmigen Deckel 23 aufgenommen ist. Der Boden 21, die Trägerplatte 22 und der Deckel 23 besitzen miteinander fluchtende Öffnungen, durch die die Anschlüsse 3 und 4 hindurchgeführt sind, wobei in den genannten Öffnungen pfropfenartige Verschlußstücke 25 angeordnet sind, welche gegebenenfalls durch Vergußmaterial gebildet sein können. Die Verschlußstücke 25 tragen Anschlußkontakte 26, über die der piezoelektrische Körper 2 mit einer elektrischen Spannung beaufschlagt werden kann.

Der Deckel 23 ist mit einem die Federhülse 20 mit radialem Abstand ummantelnden Zylinder 27 verbunden, dessen unteres Ende mit einem Innengewinde versehen ist, um den Zylinder in weiter unten dargestellter weise auf das Gehäuse eines Einspritzventiles aufschrauben zu können.

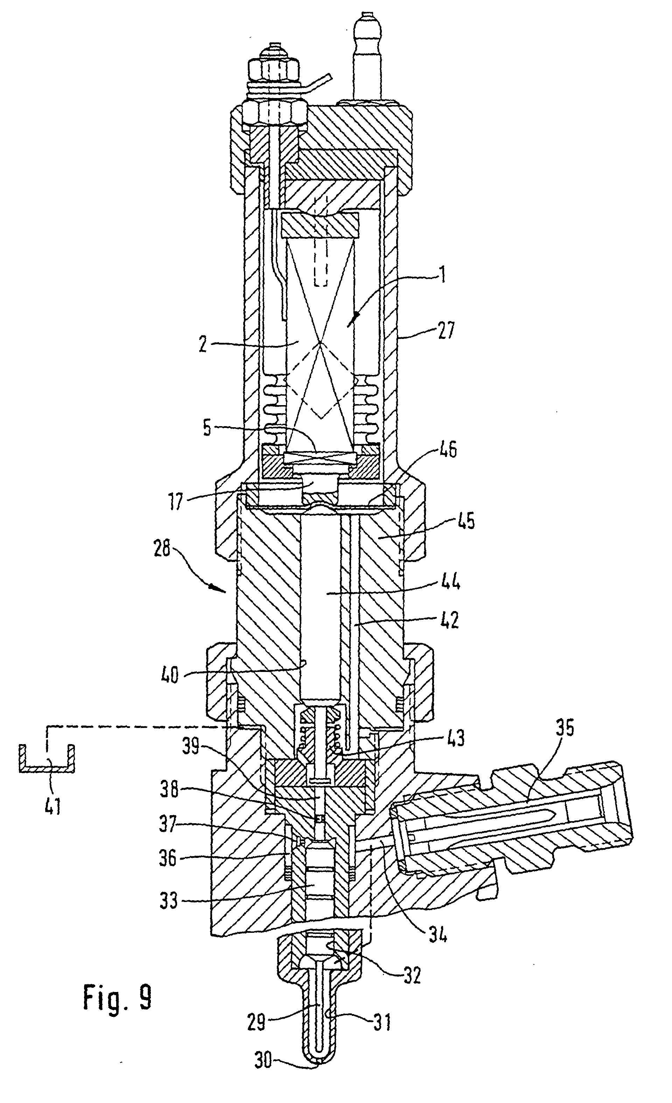

Gemäß Fig. 9 ist an einem mehrteiligen Gehäuse 28 des dargestellten Einspritzventilaggregates eine durch eine Nadel 29 gesteuerte Einspritzdüse 30 angeordnet, der über eine die Nadel 29 aufnehmende Gehäusebohrung 31 Kraftstoff unter höherem Druck zuführbar ist. Die Gehäusebohrung 31 erweitert sich nach oben in einen zylindrischen Arbeitsraum 32 für einen mit der Nadel 29 fest verbundenen, plungerartigen Stößel 33, der innerhalb des Arbeitsraumes 32 hubbeweglich aufgenommen ist. Der in Fig. 9 untere, erweiterte Endbereich des Arbeitsraumes 32 kommuniziert über eine in Fig. 9 nicht sichtbare Gehäusebohrung mit einer Querbohrung 34, die über ein Spaltfilter 35 mit einer nicht dargestellten Kraftstoffzufuhrleitung verbunden ist. Die Querbohrung 34 mündet in einen Ringraum 36, der über eine Eingangsdrossel 37 mit dem in Fig. 9 oberen Endbereich des Arbeitsraumes 32 kommuniziert. Im übrigen schließt sich an den oberen Endbereich des Arbeitsraumes 32 eine mit einer Ausgangsdrossel 38 versehene, zum Arbeitsraum 32 gleichachsige Bohrung 39 an. Die Bohrung 39 mündet in eine anschließende, gleichachsige Bohrung 40, die mit einem Entlastungsraum 41 sowie einer Ausgleichsbohrung 42 verbunden ist, die parallel zur Bohrung 40 angeordnet ist und deren Enden miteinander verbindet. In der Bohrung 40 ist ein Steuerventil 43 angeordnet, welches die zugewandte Mündung der Bohrung 39 und damit die Verbindung der Bohrung 39 mit dem Entlastungsraum 41 steuert. Das Steuerventil 43 wird mittels eines in der Bohrung 40 angeordneten Stößels 44 betätigt, der seinerseits mittels des piezoelektrischen Aktuators 1 betätigt wird. Der Aktuator 1 ist in dem Zylinder 27 untergebracht, dessen Innenraum durch eine zwischen dem anschließenden Gehäuseteil 45 und dem Zylinder 24 gehalterte Membran 46 gegen Eintritt von Kraftstoff abgedichtet sein kann.

Die dargestellte Anordnung funktioniert wie folgt:

Wenn der Aktuator 1 mit einer elektrischen spannung oder einer pulsierenden elektrischen Spannung beaufschlagt wird, führt der piezoelektrische Körper 2 pulsierende Bewegungen aus, die über den stößelartigen Fortsatz 17, welcher am piezoelektrischen Körper 2 bzw. an der daran angeordneten stirnseitigen Platte 5 angeordnet ist, auf den Stößel 44 übertragen werden, so daß derselbe das Steuerventil 43 öffnet bzw. schließt. Bei geschlossenem Steuerventil 43 beaufschlagt der Druck des über die Querbohrung 34 zugeführten Kraftstoffes beide Enden des plungerartigen Stößels 33. Da das untere Ende gegenüber dem oberen Ende einen um den Querschnitt der Nadel 29 verminderten Querschnitt besitzt, wird der Stößel 33 vom Kraftstoffdruck in Abwärtsrichtung gedrängt, so daß die Nadel 29 die Einspritzdüse 30 schließt. Sobald das Steuerventil 43 öffnet, fällt der Druck am oberen Ende des Stößels 33 ab, wobei der Druckabfall durch das Verhältnis der Drosselwiderstände der Eingangsdrossel 37 sowie der Ausgangsdrossel 38 bestimmt wird. Im Ergebnis kann damit der auf das untere Ende des Stößels 33 wirkende Druck des Kraftstoffes den Stößel 33 anheben, wobei die Nadel 29 die Einspritzdüse 30 öffnet.

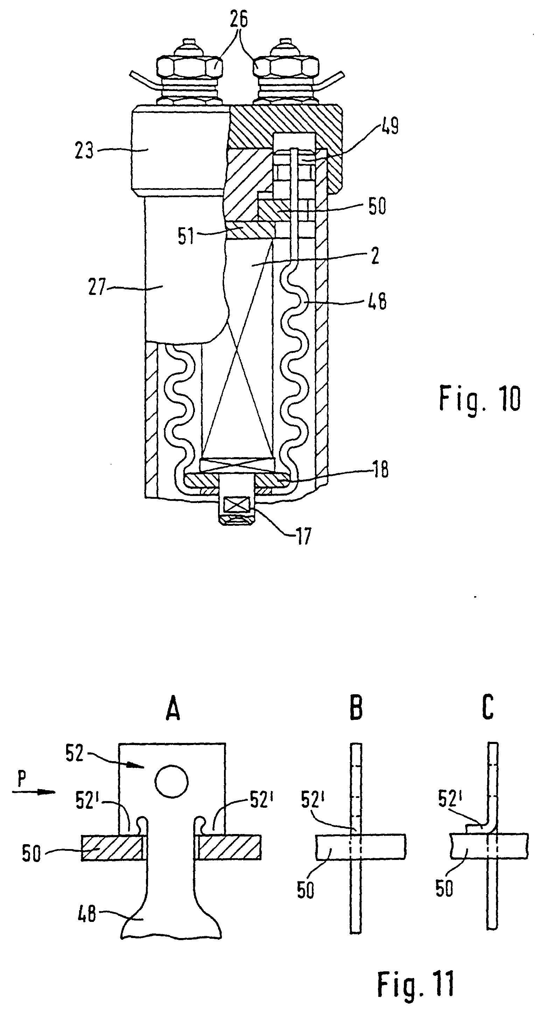

Die in Fig. 10 dargestellte (nicht beanspruchten) Ausführungsform unterscheidet sich von der Ausführungsform der Fig. 8 vor allem dadurch, daß anstelle der Federhülse 20 der Fig. 8 ein gewelltes Federband 48 angeordnet ist, welches um die vom piezoelektrischen Körper 2 abgewandte Seite des Ringflansches 18 herumgeführt ist und dort eine Öffnung für den Fortsatz 17 der Platte 16 aufweist.

Die beiden Enden des Federbandes 48 sind jeweils in einen nippelartigen Aufhänger 49 hart eingelötet (Cu-Lötung), welcher auf einem scheibenförmigen Abstütz- und Ausgleichselement 50 gelagert ist, das seinerseits auf einer Stirnplatte 51 des piezoelektrischen Körpers 2 aufliegt. Sowohl im Abstütz- bzw. Ausgleichselement 50 als auch in der Stirnplatte 51 sind zur Seite offene Schlitze zur Durchführung des Federbandes 48 angeordnet.

Anstelle der mit dem Federband 48 fest verbundenen Aufhänger 49 können gemäß dem Bild A der Fig. 11 am Federband 48 auch ankerförmige Endteile 52 einstückig angeformt sein. Diese sind im Beispiel der Fig. 11 als im wesentlichen quadratische Lappen mit einer zentralen Öffnung zum Eingriff eines Werkzeuges ausgebildet. Dabei ist jedes Endteil 52 bzw. der dasselbe bildende Lappen so bemessen, daß er den in der Stirnplatte 51 bzw. im zugeordneten Abstütz- bzw. Ausgleichselement 50 angeordneten, vom Federband 48 durchsetzten Schlitz in dessen Querrichtung zu überbrücken vermag und mit Eckbereichen 52' beidseitig des genannten Schlitzes auf einer Stirnseite des Abstütz- bzw. Ausgleichelementes 50 oder der Stirnplatte 51 abgestützt wird.

Die Übergänge zwischen den Eckbereichen 52' und dem den Schlitz durchsetzenden - relativ schmalen - Teil des Federbandes 48 sind als U-förmige oder (vorzugsweise) als schlüssellochförmige Aussparung ausgebildet, derart, daß die Eckbereiche 52' gegen die zugewandte Stirnseite des Abstütz- bzw. Ausgleichselementes 50 bzw. der Stirnplatte 51 gerichtete kurze Fortsätze des Endteiles 52 bilden und eine Rißbildung an den Übergängen vermieden wird.

Gemäß dem Bild B, welches eine erste Variante einer Seitenansicht des Endteiles 52 entsprechend dem Pfeil P im Bild A der Fig. 11 zeigt, können die Eckbereiche 52' im wesentlichen eben ausgebildet und etwa gleicher Ebene wie das übrigen Endteil 52 angeordnet sein.

Statt dessen ist es auch möglich und vorteilhaft, entsprechend dem Bild C der Fig. 11 die Enden der Eckbereiche 52' gegenüber der Ebene des Endteiles 52 abzuwinkeln, derart, daß jeweils ein abgewinkelter Teil des Eckbereiches 52' auf der zugewandten Stirnseite des Abstütz- bzw. Ausgleichselementes 50 flächig aufliegt.

## Patentansprüche

1. Piezoelektrischer Aktuator zur Betätigung von Steuerventilen oder von Einspritzventilen an Verbrennungsmotoren in Kraftfahrzeugen mit einem piezoelektrischen Körper (2), insbesondere in Form eines vielschichtigen Laminates mit aufeinander geschichteten Lagen aus piezoelektrischem bzw. piezokeramischem Material und zwischengeschalteten metallischen bzw. elektrisch leitenden, als Elektroden dienenden Schichten, wobei der Körper bei pulsierender elektrischer Beaufschlagung seiner Elektroden analog pulsierende Hübe unter Änderung des Abstandes zwischen zwei voneinander abgewandten Stirnseiten des Körpers ausführt, und mit auf den Stirnseiten des piezoelektrischen Körpers (2) angeordneten stabile Platten (5), die durch zwischen ihnen wirksamen Spannelementen (7, 8, 10) unter Druckvorspannung des piezoelektrischen Körpers (2) gegeneinander gespannt sind, **dadurch gekennzeichnet, daß** die Platten (5) mittels zumindest eines Federbügels (7, 8, 10), welcher die Platten und den dazwischenliegenden piezoelektrischen Körper (2) von außen mit Abstand um- bzw. übergreift, gegeneinander gespannt sind, wobei der zumindest eine Federbügel(7, 8, 10) in eine mittige stirnseitige Nut (6) oder eine zur Aufnahme von abgewinkelten Enden zweier Federbügel ausgebildeten Bohrung (9) der Platten eingreift.

2. Aktuator nach Anspruch 1,
**dadurch gekennzeichnet,**
**daß** zwei voneinander separate Federbügel (8,10) angeordnet sind, die jeweils im wesentlich C-förmig ausgebildet sind und mit ihren Enden die Platten (5) übergreifen.

3. Aktuator nach Anspruch 1,
**dadurch gekennzeichnet,**
**daß** der Federbügel (7) als ringförmig geschlossenes Teil ausgebildet ist.

4. Aktuator nach einem der Ansprüche 1 bis 3,
**dadurch gekennzeichnet,**
**daß** seitlich des piezoelektrischen Körpers (2) erstreckte Bereiche des Federbügels bzw. der Federbügel (7,8,10) Wellenform bzw. ein oder mehrere Sicken aufweisen.

## Claims

1. Piezoelectric actuator for the actuation of control valves or of injection valves on internal combustion engines in motor vehicles, with a piezoelectric body (2), particularly in the form of a multilayer laminate with piles layered one on the other and consisting of piezoelectric or piezoceramic material and with interposed metallic or electrically conducting layers serving as electrodes, the body, in the case of pulsating electrical action upon its electrodes, executing similarly pulsating strokes, at the same time changing the distance between two end faces of the body which face away from one another, and with stable plates (5) which are arranged on the end faces of the piezoelectric body (2) and which are tensioned relative to one another by means of tensioning elements (7, 8, 10) active between them, with the piezoelectric body (2) at the same time being subjected to pressure prestress, **characterized in that** the plates (5) are tensioned relative to one another by means of at least one spring clip (7, 8, 10) which from outside, with a clearance, engages respectively around and over the plates and the piezoelectric body (2) lying between them, the at least one spring clip (7, 8, 10) engaging into a central end-face groove (6) of the plate or into a bore (9) of the plates which is designed to receive angled ends of two spring clips.

2. Actuator according to Claim 1, **characterized in that** two spring clips (8, 10) separate from one another are arranged, which in each case are of essentially C-shaped design and engage with their ends over the plates (5).

3. Actuator according to Claim 1, **characterized in that** the spring clip (7) is designed as an annularly closed part.

4. Actuator according to one of Claims 1 to 3, **characterized in that** regions of the spring clip or spring clips (7, 8, 10) which are extended laterally with respect to the piezoelectric body (2) have a wave shape or one or more beads.

## Revendications

1. Actionneur piézoélectrique permettant d'actionner des soupapes de commande ou des soupapes d'injection de moteurs à combustion interne dans des véhicules automobiles, comportant un corps piézoélectrique (2), en particulier sous la forme d'un laminé à plusieurs couches doté de couches déposées les unes sur les autres et constituées d'un matériau piézoélectrique ou piézocéramique, et de couches métalliques ou conductrices d'électricité placées entre celles-ci et servant d'électrodes, le corps décrivant, lors d'une sollicitation électrique à impulsions de ses électrodes, des courses à impulsions analogues entraînant une modification de la distance entre deux faces frontales du corps opposées l'une à l'autre, et comportant sur les faces frontales du corps piézoélectrique (2), des plaques stables (5) serrées l'une contre l'autre par des éléments de serrage (7, 8, 10) agissant entre elles sous la précontrainte de compression du corps piézoélectrique (2),
**caractérisé en ce que**
les plaques (5) sont serrées l'une contre l'autre au moyen d'au moins un étrier de ressort (7, 8, 10) qui entoure ou dépasse de l'extérieur, avec une certaine distance, les plaques et le corps piézoélectrique (2) situé entre elles, l'au moins un étrier de ressort (7, 8, 10) s'engrenant dans une rainure (6) médiane située du côté frontal ou dans un alésage (9) des plaques configuré pour accueillir des extrémités déroulées de deux étriers de ressort.

2. Actionneur selon la revendication 1,
**caractérisé en ce que**
deux étriers de ressort (8, 10) séparés l'un de l'autre sont pour l'essentiel en forme de C dont les extrémités dépassent par-dessus les plaques (5).

3. Actionneur selon la revendication 1,
**caractérisé en ce que**
l'étrier de ressort (7) est configuré sous forme de pièce annulaire fermée.

4. Actionneur selon l'une des revendications 1 à 3,
**caractérisé en ce que**
des zones de l'étrier de ressort ou des étriers de ressort (7, 8, 10) s'étendant latéralement par rapport au corps piézoélectrique (2) présentent une forme ondulée ou une ou plusieurs moulures.
